(19) Europäisches Patentamt
European Patent Office
Office européen des brevets

(11) **EP 2 544 514 B1**

(12) **EUROPÄISCHE PATENTSCHRIFT**

(45) Veröffentlichungstag und Bekanntmachung des Hinweises auf die Patenterteilung:
**06.03.2019 Patentblatt 2019/10**

(51) Int Cl.:
**G01N 27/24** *(2006.01)* **H05K 3/00** *(2006.01)*
**H05K 1/02** *(2006.01)*

(21) Anmeldenummer: **11172700.4**

(22) Anmeldetag: **05.07.2011**

(54) **Verfahren zur Überprüfung einer korrekten Klebung eines Substrates auf einem elektrisch und thermisch leitfähigen Körper**

Method for testing whether a substrate is sticking to an electrically and thermally conductive body correctly

Procédé de contrôle du collage correct d'un substrat sur un corps conducteur électrique ou thermique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**09.01.2013 Patentblatt 2013/02**

(73) Patentinhaber: **Pierburg Pump Technology GmbH 41460 Neuss (DE)**

(72) Erfinder:
• **Friede, Hagen**
  **04736 Waldheim (DE)**
• **Selter, Hartmut**
  **47929 Grefrath (DE)**
• **Becker, Claus**
  **58636 Iserlon (DE)**
• **Schreckenberg, Stephan**
  **50259 Pulheim-Stommeln (DE)**

(74) Vertreter: **Rütten, Peter Laurenz et al Ter Smitten Eberlein Rütten Patentanwälte Partnerschaftsgesellschaft Burgunderstrasse 29 40549 Düsseldorf (DE)**

(56) Entgegenhaltungen:
**DE-A1- 19 914 497    JP-A- 4 344 402
JP-A- 7 249 667    JP-A- 56 128 403
JP-A- 61 070 403    JP-A- 2003 207 304**

• **"Fortgeschrittenen-Praktikum Versuch 5: Dielektrische Funktion", , 31. Januar 2011 (2011-01-31), XP55012077, Halle, Germany Gefunden im Internet: URL:http://positron.physik.uni-halle.de/F-Praktikum/PDF/5_dielektrische_Funktion.pdf [gefunden am 2011-11-14]**
• **"Der Einfluss von Luftspalten" In: Albrecht Rost: "Messung dielektrischer Stoffeigenschaften", 1978, Akademie Verlag Berlin, Berlin, XP55012084, Seiten 1-45, * Seite 33 - Seite 34 ***

EP 2 544 514 B1

## Beschreibung

Die Erfindung betrifft ein Verfahren zur Überprüfung einer korrekten Klebung eines Substrates auf einem elektrisch und thermisch leitfähigen Körper, wobei zwischen dem Substrat, auf dessen Oberseite eine elektrische Schaltung mit Leiterbahnen und elektronischen Bausteinen angeordnet ist und dem elektrisch leitfähigem Körper, der an der Rückseite des Substrats befestigt ist, eine Klebeschicht ausgebildet ist.

Zur Steuerung von elektromotorisch angetriebenen Pumpen werden Substrate mit Steuerungs- und Leistungsbausteinen, die über Leiterbahnen miteinander elektrisch verbunden sind, genutzt. Sowohl die Leistungsbausteine als auch je nach Einbauort die Umgebung erzeugen Wärme, die von den elektrischen Bauteilen auf dem jeweiligen Substrat abgeführt werden muss, um Schädigungen der Schaltungen durch zu hohe thermische Belastungen zu vermeiden. Aus diesem Grund werden die Substrate auf Kühlkörpern befestigt, die üblicherweise aus einem gut wärmeleitenden Metall, insbesondere Aluminium hergestellt sind und entweder an ihrer zum Substrat entgegengesetzten Seite von einem Kühlmittel umströmt sind, um Wärme über das Kühlmittel abzuführen oder Rippen aufweisen, die eine Wärmeabfuhr an eine Luftströmung ermöglichen. Diese Befestigung des Substrats am Aluminiumkühlkörper kann kraftschlüssig, stoffschlüssig oder formschlüssig erfolgen. Damit eine ausreichende Wärmeabfuhr vom Substrat zum Kühlkörper auch bei hoher thermischer Belastung sichergestellt wird, muss die Anbindung möglichst flächig und mit möglichst geringem Abstand zum anzubindenden Kühlkörper ausgeführt werden.

Entsprechend wird in der DE 100 51 945 C1 eine Anbindung eines Substrats für ein Kraftfahrzeugelektronikbauteil offenbart, bei dem die Verbindung mittels eines Wärmeleitklebers erfolgt.

Aus der EP 2521430 A1 (Stand der Technik nach Artikel 54(3) EPÜ) ist es bekannt, diese Verklebung mittels Erzeugung eines Vakuums zwischen dem Kühlkörper und einem Keramiksubstrat durchzuführen, wodurch vollflächige und dünne Klebeschichten auch bei zu Bruch neigenden keramischen Substraten erreichbar sind.

Dabei ist die Wärmeleitung besser je dünner und vollflächiger die Klebeschicht ist. Aus diesem Grund ist es erforderlich, bei der Überprüfung der Klebung sowohl eine Aussage zur Dicke der Klebeschicht als auch zu gegebenenfalls vorhandenen Lufteinschlüssen im Bereich der Klebeschicht machen zu können.

Auch ist es aus der JPH 04344402 A bekannt, die Dicke eines mehrschichtigen Substrates durch Messung der Kapazität eines Kondensators zu bestimmen, der durch eine leitende Schicht auf einer Vorderseite und einer Rückseite des Substrates gebildet wird. Eine Aussage zur Güte einer Klebeverbindung zwischen Kühlkörpern und Substraten wird nicht getroffen.

Aus der DE 199 14 497 A1 ist es bekannt, eine Leiterplatte mit elektrischen Bauteilen mittels eines Wärmeleitklebers auf einen metallischen Sockel zu kleben, der wiederum über Schrauben mit einer Grundplatte verbunden ist.

Es stellt sich daher die Aufgabe, ein Verfahren zur Überprüfung einer korrekten Klebung eines Substrates auf einem elektrisch und thermisch leitfähigen Körper bereitzustellen, welches eine zuverlässige Aussage zur Klebeschichtdicke und Vollflächigkeit der Klebung und somit zur Güte der Verklebung ermöglicht, so dass eine ausreichende Wärmeableitung der Bausteine sichergestellt werden kann.

Diese Aufgabe wird durch ein Verfahren zur Überprüfung einer korrekten Klebung eines Substrates auf einem elektrisch und thermisch leitfähigen Körper mit den Merkmalen des Anspruchs 1 gelöst.

Dadurch, dass die Leiterbahnen und der elektrisch leitfähige Körper jeweils mittels Kontaktfahnen an den entgegengesetzten Polen einer Spannungsquelle angeschlossen werden, wobei über die gemessene Kapazität auf die Güte der Klebeschicht geschlossen wird, wird eine zerstörungsfreie Schichtdickenmessung und Gütebestimmung der Verklebung auf einfache Weise ermöglicht. Dabei dienen auf der einen Seite der elektrisch und thermisch leitfähige Körper und auf der anderen Seite die Leiterbahnen als gegenüberliegende Platten eines Plattenkondensators, wobei zwischen den Platten eine bekannte Dicke des nicht leitenden Schaltungsträgers und eine zu bestimmende Dicke des Klebers angeordnet sind. Die Kapazität ist dabei einerseits von der Schichtdicke und andererseits von der Dielektrizitätskonstante der Klebeschicht abhängig, welche sich bei Lufteinschlüssen ändert, so dass die Kapazität ein Maß für die Güte und die Dicke der Klebeschicht darstellt.

Vorzugsweise werden die Kontaktfahnen über die Versorgungskontakte der Schaltung mit den Leiterbahnen verbunden. Die Versorgungskontakte sind einfach erreichbar. Des Weiteren ist eine Anbindung an dieser Position reproduzierbar, wodurch Messfehler durch kapazitive Kopplungen zwischen den Leitungen der Kontaktfahnen herausrechenbar sind.

In einer Weiterbildung des erfindungsgemäßen Verfahrens wird zunächst die Dielektrizitätskonstante des verwendeten Klebers bestimmt, wodurch fehlerhafte Messergebnisse aufgrund von Kleberlosen mit variierender Dielektrizitätskonstante entfallen.

Des Weiteren wird zur Verbesserung der Messergebnisse vorteilhafterweise unmittelbar vor dem Kontaktieren der Kontaktfahnen mit dem leitfähigem Körper und den Leiterbahnen eine Offsetkompensation durchgeführt. Durch diese Nullung der Messung bei definiertem Abstand der Kontaktfahnen zum Substrat werden die Einflüsse einer kapazitiven Kopplung oder der Luftfeuchte weitestgehend eliminiert.

Vorzugsweise wird die gemessene Kapazität mit einem oberen und einem unteren Grenzwert für die Kapazität verglichen und falls die Kapazität in dem Intervall zwischen dem unteren Grenzwert und dem oberen Grenzwert liegt, auf eine korrekte Verklebung geschlossen. Das Intervall kann dabei relativ klein gewählt werden, da eine hohe Messgenauigkeit vorliegt. Bei Einhaltung der Grenzwerte kann somit auf eine vollflächige ausreichend dünne Verklebung geschlossen werden.

Ein derartiges Verfahren stellt eine Klebung zwischen dem Substrat und einem thermisch und elektrisch leitfähigem Körper sicher, mit der eine ausreichende Wärmeableitung des thermisch belasteten Substrats sichergestellt wird, so dass ein Ausfall thermisch empfindlicher elektronischer Bausteine zuverlässig vermieden wird. Dabei sind Aussagen zur Güte der Verklebung sowohl bezüglich der Schichtdicke als auch eventueller Lufteinschlüsse möglich.

Das erfindungsgemäße Verfahren wird im Folgenden anhand der Figuren beschrieben.

Figur 1 zeigt eine schematische Seitenansicht eines auf einen Kühlkörper geklebten Substrats.

Figur 2 zeigt eine Draufsicht auf das Substrat mit Anbindung der Kontaktfahnen in schematischer Darstellung.

Figur 3 zeigt den Ablaufplan einer Prüfvorschrift.

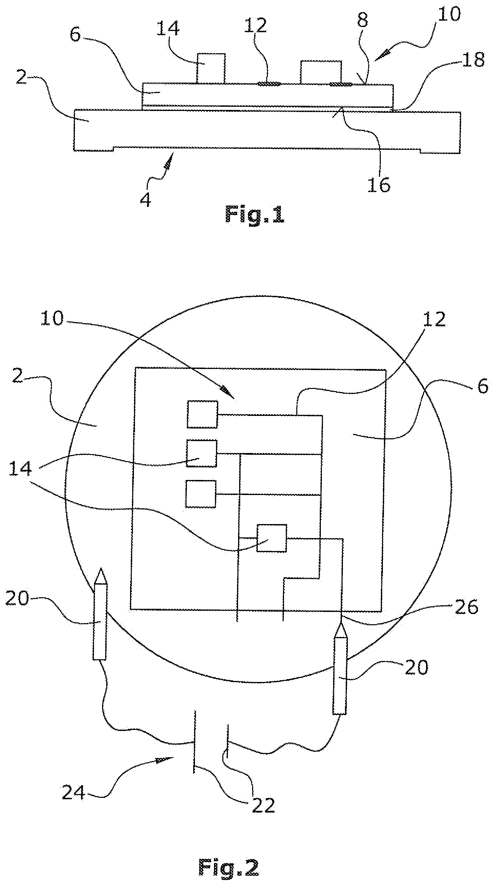

In Figur 1 ist ein Körper 2 dargestellt, der aus einem thermisch und elektrisch leitenden Metall, vorzugsweise aus Aluminium hergestellt wird und als Kühlkörper dient, der nach dem Einbau beispielsweise an seiner Unterseite 4 von einem flüssigen Kühlmittel umströmt wird.

Auf diesem Körper 2 ist ein Substrat 6 befestigt, welches beispielsweise aus Keramik hergestellt sein kann und auf dessen Oberseite 8 eine elektrische Schaltung 10 angeordnet ist, die aus aufgedruckten elektrischen Leiterbahnen 12 und damit verbundenen elektronischen Bausteinen 14 besteht, welche beispielsweise elektrische Leistungshalbleiter beinhalten. Selbstverständlich sind auch andere Schaltungsmaterialien wie FR4 sowie andere Verfahren zur Herstellung der Leiterbahnen beispielsweise durch eine geätzte oder laminierte Kupferfolie denkbar.

Die Verbindung zwischen der zur elektrischen Schaltung 10 entgegengesetzten Rückseite 16 des Substrates 6 und dem Kühlkörper 2 erfolgt mittels eines Wärmeleitklebers, der elektrisch isolierend und thermisch leitend wirkt. Er weist eine Viskosität von etwa 200.000 mPas auf, so dass es sich um einen pastösen Kleber handelt, der gut zu dosieren ist und nicht zum Tropfen neigt. Dieser wird spiralförmig als Kleberaupe aufgetragen und anschließend unter Vakuum die Luft zwischen den Gängen gezogen, wodurch mit anschließender Beaufschlagung der Oberseite 8 des Substrats 6 mit Atmosphärendruck eine flächige Verklebung aufgrund der Druckdifferenz zwischen Oberseite 8 und Rückseite 16 erfolgen soll.

Die entstehende Klebeschicht 18 sollte ca.

100μm dick und sehr gleichmäßig sein. Eine minimale Dicke von ca. 50μm ist dabei durch die Beimischung von Feststoffen in den pastösen Kleber vorgegeben. So wird eine optimierte Wärmeableitung vom Substrat 6 beziehungsweise den auf dem Substrat 6 angeordneten elektronischen Bausteinen 14 in Richtung zum Kühlkörper 2 sichergestellt.

Erfindungsgemäß wird zur Überprüfung der Güte der Klebung und somit des Wärmeübergangs der elektrisch leitende Körper 2 und die Leiterbahnen 12, wie in Figur 2 dargestellt, mittels zweier Kontaktfahnen 20 an die entgegengesetzten Pole 22 einer Spannungsquelle 24 angeschlossen. Die Verbindung zu den Leiterbahnen 12 erfolgt dabei über Versorgungskontakte 26 der elektrischen Schaltung 10.

Diese Kontaktierung hat zur Folge, dass die elektrischen Leiterbahnen 12 eine erste Platte eines Kondensators und der Körper 2 eine entgegengesetzte zweite Platte eines Kondensators bildet, der eine Kapazität aufweist, die von dem zwischen den Platten liegenden isolierenden Material bestehend aus dem Substrat 6 und der Klebeschicht 18 abhängig ist.

Die Kapazität eines Plattenkondensators berechnet sich in bekannter Weise aus der Gleichung (1):

$$C = \frac{A}{\dfrac{d}{\varepsilon_0 \cdot \varepsilon_r}} \qquad (1)$$

Wobei

C   die Kapazität ist

A   die wirksame sich überlappende Fläche der beiden Platten ist

d   der Abstand der Platten ist

$\varepsilon_r$   die relative Dielektrizitätskonstante des Materials zwischen den Platten ist

$\varepsilon_0$   die absolute Dielektrizitätskonstante ist $(8{,}85419 \times 10^{-12} ASV^{-1}\,m^{-1})$

Im vorliegenden Fall ergibt sich eine zweischichtiger Aufbau zwischen den Platten des Kondensators, so dass sich Gleichung (2) ergibt:

$$C = \frac{A}{\dfrac{d_1}{\varepsilon_0 \cdot \varepsilon_{r1}} + \dfrac{d_2}{\varepsilon_0 \cdot \varepsilon_{r2}}} \qquad (2)$$

Wobei

$d_1$   die Schichtdicke des Substrats ist

$d_2$   die Schichtdicke der Klebeschicht ist

$\varepsilon_{r1}$   die relative Dielektrizitätskonstante des Substratmaterials ist

$\varepsilon_{r2}$    die relative Dielektrizitätskonstante des Klebers ist

Die Unbekannte dieser Gleichung (2) ist die Dicke der Klebeschicht $d_2$, die entsprechend durch Umstellung der Gleichung (2) ermittelt wird:

$$d_2 = \varepsilon_{r2} \cdot \left( \frac{\varepsilon_0 \cdot A}{C} - \frac{d_1}{\varepsilon_{r1}} \right) \qquad (3)$$

Während die verwendeten Substrate 6 sowohl bezüglich ihrer Dicke als auch bezüglich ihrer relativen Dielektrizitätskonstante bekannt sind und auch die überlappende Fläche der beiden als Platten wirkenden Teile des Kondensators bekannt ist, muss die relative Dielektrizitätskonstante des Klebers möglichst für jedes neu hergestellte Los vorab in bekannter Weise bestimmt werden. Anschließend erfolgt die Messung der Kapazität, woraus mit Hilfe der Gleichung (3) dann die Dicke beziehungsweise Güte der Klebeschicht bestimmt werden kann. Die Messung der Kapazität kann beispielsweise mittels eines Wavetek LCR 55 durchgeführt werden.

Zur Eliminierung der Luftfeuchte sowie der kapazitiven Kopplung der beiden Leiterdrähte der Kontaktfahnen 20 wird unmittelbar vor dem Aufsetzen der Kontaktfahnen 20 auf die Versorgungskontakte 26 und den Körper 2 in einem definierten Abstand von beispielsweise 1cm eine Offsetkompensation durchgeführt werden. Dabei sind die Kontaktfahnen 20 im Übrigen in möglichst gleicher Weise zueinander anzuordnen wie bei der Durchführung der eigentlichen Messung.

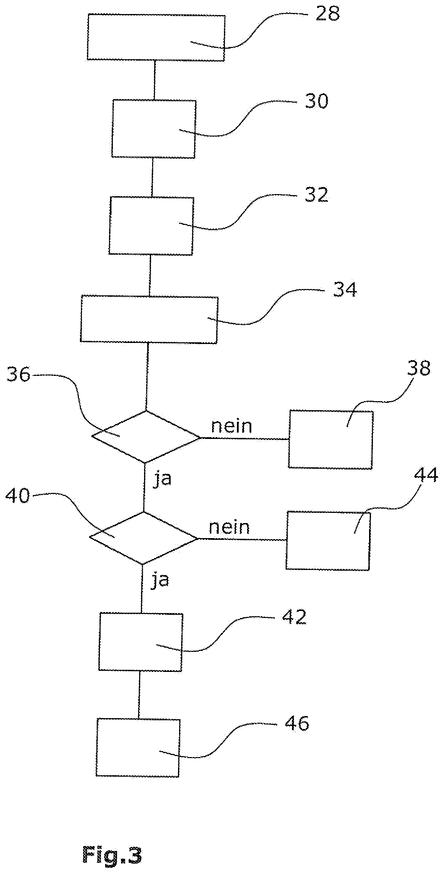

Durch entsprechend durchgeführte Referenzmessungen wird ein oberer Grenzwert $C_o$ von beispielsweise 300pF sowie ein unterer Grenzwert $C_u$ von beispielsweise 225pF als Intervall für die Kapazität festgelegt, in dem auf eine ausreichende Güte der Klebung geschlossen wird. So wird entsprechend des Ablaufschemas in Figur 3 die Kapazitätsmessung in Schritt 28 begonnen. Der untere und der obere Grenzwert werden im folgenden Schritt 30 eingegeben. Die Messung wird durch Anlegen der Spannung an den definierten Punkten in Schritt 32 begonnen und ein Wert $K_{ist}$ gemessen. Selbstverständlich können mehrere Messungen durchgeführt werden und diese in Schritt 34 einer Messwertkorrektur beispielsweise durch Varianzschätzung mittels des Gauß'schen Fehlerfortpflanzungsgesetzes unterzogen werden, so dass sich eine korrigierte Kapazität $C_{kor}$ ergibt. Selbstverständlich können auch andere bekannte Messwertkorrekturverfahren verwendet werden. Im folgenden Schritt 36 wird der korrigierte Messwert $C_{kor}$ mit dem unteren Grenzwert $C_u$ verglichen. Sollte $C_{kor}$ kleiner sein als $C_u$ wird die Klebung als nicht in Ordnung bewertet und die Einheit aus Substrat 6 und Körper 2 aussortiert, wie durch Bezugszeichen 38 dargestellt. Andernfalls wird der korrigierte Messwert $C_{kor}$ im folgenden Schritt 40 mit dem oberen Grenzwert $C_o$ verglichen. Es wird mit Schritt 42 fortgefahren und die Einheit als in Ordnung bewertet, falls $C_{kor}$ kleiner sein sollte als $C_o$. Andernfalls wird mit Schritt 44 fortgefahren und die Einheit als nicht in Ordnung bewertet. Mit Schritt 46 wird das Verfahren abgeschlossen.

Es wird deutlich, dass bei zu großer Dicke der Klebeschicht 18 die gemessene Kapazität kleiner wird und somit eine Abweichung nach unten aus dem Intervall der Grenzwerte für die Kapazität folgt. Damit werden Teile, bei denen Verunreinigungen im Kleber vorhanden sind, die zu einer größeren Schichtdicke führen, aufgefunden. Sollte ein Lufteinschluss bestehen, wird die tatsächliche relative Dielektrizitätskonstante kleiner sein als angenommen. Daraus folgt ebenfalls eine Abweichung der gemessenen Kapazität nach unten. Sollte über einen bestimmten Bereich kein Kleber unter dem Substrat sein, wird die Platte durch das Vakuum vollflächig, jedoch nicht ausreichend befestigt, auf dem Kühlkörper 2 aufliegen, wodurch die gemessene Kapazität nach oben aus dem Intervall fallen wird. Somit folgt, dass alle relevanten Fehler in der Verklebung durch diese Art der Messung aufgefunden werden, so dass eine Auslieferung fehlerhafter Teile zuverlässig vermieden werden kann.

Dieses Verfahren eignet sich somit zur Messung von extrem dünnen und gut wärmeleitenden Kleberschichten, so dass ein Ausfall der Elektronik aufgrund der Sicherstellung der vollflächigen, dünnen Klebeschichten auch bei hohen thermischen Belastungen zuverlässig vermieden werden kann.

Es sollte deutlich sein, dass der Schutzbereich der Anmeldung nicht auf das beschriebene Ausführungsbeispiel beschränkt ist. Verschiedene Modifikationen und Erweiterungen zur Optimierung des Verfahrens, wie eine Festlegung der Messpunkte und Automatisierung der Messungen sind denkbar, ohne den Schutzbereich des Hauptanspruchs zu verlassen.

**Patentansprüche**

1. Verfahren zur Überprüfung einer korrekten Klebung eines Substrates (6) auf einem elektrisch und thermisch leitfähigen Körper (2), wobei zwischen dem Substrat (6), auf dessen Oberseite (8) eine elektrische Schaltung (10) mit Leiterbahnen (12) und elektronischen Bausteinen (14) angeordnet ist und dem elektrisch und thermisch leitfähigen Körper (2), der an der Rückseite (16) des Substrats (6) befestigt ist, eine Klebeschicht (18) ausgebildet ist,
 **dadurch gekennzeichnet, dass**
 die Leiterbahnen (12) und der elektrisch und thermisch leitfähige Körper (2) jeweils mittels Kontaktfahnen (20) an den entgegengesetzten Polen (22) einer Spannungsquelle (24) angeschlossen werden, wobei über die gemessene Kapazität auf die Güte der Klebeschicht (18) geschlossen wird.

2. Verfahren zur Überprüfung einer korrekten Klebung eines Substrates auf einem elektrisch und thermisch leitfähigen Körper nach Anspruch 1,
**dadurch gekennzeichnet, dass**
die Kontaktfahnen (20) über die Versorgungskontakte (26) der Schaltung (10) mit den Leiterbahnen (12) verbunden werden.

3. Verfahren zur Überprüfung einer korrekten Klebung eines Substrates auf einem elektrisch und thermisch leitfähigen Körper nach einem der Ansprüche 1 oder 2,
**dadurch gekennzeichnet, dass**
zunächst die Dielektrizitätskonstante des verwendeten Klebers bestimmt wird.

4. Verfahren zur Überprüfung einer korrekten Klebung eines Substrates auf einem elektrisch und thermisch leitfähigen Körper nach einem der vorhergehenden Ansprüche,
**dadurch gekennzeichnet, dass**
unmittelbar vor dem Kontaktieren der Kontaktfahnen (20) mit dem elektrisch und thermisch leitfähigen Körper (2) und den Leiterbahnen (12) eine Offsetkompensation durchgeführt wird.

5. Verfahren zur Überprüfung einer korrekten Klebung eines Substrates auf einem elektrisch und thermisch leitfähigen Körper nach einem der vorhergehenden Ansprüche,
**dadurch gekennzeichnet, dass**
die gemessene Kapazität (C) mit einem oberen Grenzwert ($C_o$) und einem unteren Grenzwert ($C_u$) für die Kapazität verglichen wird und dass, falls die Kapazität in dem Intervall zwischen dem unteren Grenzwert ($C_u$) und dem oberen Grenzwert ($C_o$) liegt, auf eine korrekte Verklebung geschlossen wird.

**Claims**

1. A method of verifying the correct adhesion of a substrate (6) on an electrically and thermally conductive body (2), wherein an adhesive layer (18) is formed between the substrate (6), on the top face (8) of which an electric circuit (10) with conductive paths (12) and electronic components (14) is arranged, and the electrically and thermally conductive body (2) fastened to the rear face (16) of the substrate (6), **characterized in that**
the conductive paths (12) and the electrically and thermally conductive body (2) are each connected to the opposite terminals (22) of a voltage source (24) by means of contact tabs (20), the quality of the adhesive layer (18) being concluded from the capacity measured.

2. A method of verifying the correct adhesion of a substrate on an electrically and thermally conductive body as defined in claim 1, **characterized in that** the contact tabs (20) are connected with the conductive paths (12) via the supply contacts (26) of the circuit (10).

3. A method of verifying the correct adhesion of a substrate on an electrically and thermally conductive body as defined in one of claims 1 or 2, **characterized in that** the dielectric constant of the adhesive used is determined first.

4. A method of verifying the correct adhesion of a substrate on an electrically and thermally conductive body of one of the preceding claims, **characterized in that** an offset compensation is performed immediately prior to connecting the contact tabs (20) with the electrically and thermally conductive body (2) and the conductive paths (12).

5. A method of verifying the correct adhesion of a substrate on an electrically and thermally conductive body of one of the preceding claims, **characterized in that** the measured capacity (C) is compared with an upper limit value ($C_o$) and a lower limit value ($C_u$) for the capacity, and **in that**, if the capacity falls into an interval between the upper limit value ($C_o$) and a lower limit value ($C_u$), a correct adhesion is concluded therefrom.

**Revendications**

1. Procédé de contrôle du collage correct d'un substrat (6) sur un corps (2) conducteur électrique ou thermique, une couche adhésive (18) étant formée entre le substrat (6), sur la face supérieure (8) duquel un circuit électrique (10) avec pistes conductrices (12) et composants électroniques (14) est disposé, et ledit corps (2) conducteur électrique ou thermique monté sur la face arrière (16) du substrat (6),
**caractérisé en ce que**
les pistes conductrices (12) et ledit corps (2) conducteur électrique ou thermique sont chacun reliés aux pôles (22) opposés d'une source de tension (24) par des lames de contact (20), la qualité de la couche adhésive (18) étant conclue de la capacité mesurée.

2. Procédé de contrôle du collage correct d'un substrat (6) sur un corps (2) conducteur électrique ou thermique selon la revendication 1, **caractérisé en ce que** les lames de contact (20) sont reliées aux pistes conductrices (12) par les contacts d'alimentation (26) du circuit (10).

3. Procédé de contrôle du collage correct d'un substrat (6) sur un corps (2) conducteur électrique ou thermique selon la revendication 1 ou 2, **caractérisé en ce que**, d'abord, l'on détermine la constante diélectrique de la colle utilisée.

4. Procédé de contrôle du collage correct d'un substrat (6) sur un corps (2) conducteur électrique ou thermique selon l'une quelconque des revendications précédentes, **caractérisé en ce que** juste avant la mise en contact des lames de contact (20) avec ledit corps (2) conducteur électrique ou thermique et les pistes conductrices (12), une compensation d'offset est effectuée.

5. Procédé de contrôle du collage correct d'un substrat (6) sur un corps (2) conducteur électrique ou thermique selon l'une quelconque des revendications précédentes, **caractérisé en ce que** la capacité mesurée (C) est comparée à un valeur limite supérieur ($C_o$) et un valeur limite inférieur ($C_u$) et, si la capacité est dans l'intervalle entre le valeur limite inférieur ($C_u$) et le valeur limite supérieur ($C_o$), l'on conclut à un collage correct.

**Fig.1**

**Fig.2**

28

30

32

34

36        nein        38

ja

40        nein        44

ja

42

46

Fig.3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10051945 C1
- EP 2521430 A1
- JP H04344402 A
- DE 19914497 A1